# EUROPÄISCHE PATENTSCHRIFT

(11) **EP 3 935 718 B1**
(45) Veröffentlichungstag und Bekanntmachung des Hinweises auf die Patenterteilung: **17.01.2024**
(21) Anmeldenummer: 20708477.3
(22) Anmeldetag: 02.03.2020
(51) Int. Cl.: H05K 1/18, H05K 3/46

(54) **STEUERGERÄT FÜR EIN LENKSYSTEM EINES KRAFTFAHRZEUGS, ELEKTROMECHANISCHE KRAFTFAHRZEUGSERVOLENKUNG UND STEER-BY-WIRE LENKSYSTEM**
CONTROL DEVICE FOR A STEERING SYSTEM OF A MOTOR VEHICLE, ELECTROMECHANICAL POWER STEERING MECHANISM FOR A MOTOR VEHICLE AND STEER-BY-WIRE STEERING SYSTEM
APPAREIL DE COMMANDE DU SYSTÈME DE DIRECTION D'UN VÉHICULE À MOTEUR, DIRECTION ASSISTÉE ÉLECTROMÉCANIQUE DE VÉHICULE À MOTEUR ET SYSTÈME DE DIRECTION À COMMANDE ÉLECTRIQUE

(30) Priorität: 08.03.2019 DE 102019203160
(43) Veröffentlichungstag der Anmeldung: 12.01.2022
(73) Patentinhaber: thyssenkrupp AG, 45143 Essen (DE); thyssenkrupp Presta AG, 9492 Eschen (LI)
(72) Erfinder: HORVATH, Gergely, 6085 Fülöpszállás (HU)
(74) Vertreter: thyssenkrupp Intellectual Property GmbH
(86) Internationale Anmeldenummer: PCT/EP2020/055458
(87) Internationale Veröffentlichungsnummer: WO 2020/182522

(56) Entgegenhaltungen:
- EP-A1- 2 244 359
- EP-A1- 2 824 014
- EP-A1- 3 220 096
- WO-A1-2017/205576
- DE-A1-102018 128 594

## Beschreibung

### Beschreibung

Die Erfindung betrifft ein Steuergerät für ein Lenksystem eines Kraftfahrzeugs nach dem Oberbegriff des Anspruchs 1, eine elektromechanische Kraftfahrzeugservolenkung nach dem Oberbegriff des Anspruchs 8 und ein Steer-by-Wire Lenksystem nach dem Oberbegriff des Anspruchs 9.

Aus DE 10 2009 002524 A1 ist ein Steuergerät für den Betrieb einer elektrischen Hilfs- oder Fremdkraftlenkung bekannt. Im Inneren des Steuergeräts befindet sich ein Schaltungsträger, auf dem ein Mikrocontroller zu Steuer- und Regelungszwecken angeordnet ist. Des Weiteren befindet sich eine elektronische Endstufe auf dem Träger, die zur Ansteuerung eines Elektromotors dient. Das Steuergerät ist mittels eines Batterie-Stecksystems mit dem positiven und negativen Pol der Batterie über entsprechende Kontaktstellen verbunden. Nachteilig ist, dass die Anordnung der gesamten Geräteelektronik auf einem einteiligen Schaltungsträger im Inneren des Steuergeräts viel Fläche benötigt. Entsprechend großbauende Steuergeräte sind die Folge.

Aus EP 2 244 359 A1 ist ein Motorsteuergerät für eine Kraftfahrzeuglenkung mit drei mehrschichtigen Leiterplatten bekannt. Die erste und die zweite mehrschichtige Leiterplatte sind Steuerplatinen zur Steuerung des Antriebs eines Elektromotors, während auf der dritten mehrschichtigen Leiterplatte die Bauteile des Motortreibers angeordnet sind. Die erste Leiterplatte ist elektrisch mit der zweiten Leiterplatte über eine bandförmige flexible Platine und an den beiden Enden der flexiblen Platine vorgesehenen Steckverbindern verbunden. Die zweite Leiterplatte ist mit der dritten Leiterplatte ebenfalls über eine bandförmige flexible Platine und an den beiden Enden der flexiblen Platine vorgesehenen Steckverbindern elektrisch verbunden.

EP 2 824 014 A1 beschreibt ein elektrisches Antriebsgerät für eine elektrische Servolenkung mit einer elektronischen Steuereinheit, die koaxial zu einer Motorwelle angeordnet ist und eine Wärmesenke, eine Leistungsplatine und eine Steuerplatine enthält, die in der genannten Reihenfolge am Antriebsende der Motorwelle angeordnet sind. Leistungsplatine und Steuerplatine sind über eine Steckverbindung miteinander verbunden.

Durch die stetig wachsende Anzahl von Steuergeräten in Kraftfahrzeugen sinkt bei gleichbleibender Fahrzeuggröße der für jedes Steuergerät zur Verfügung stehende Bauraum. Eine Möglichkeit den erforderlichen Bauraum zu reduzieren, ist es, mehrere kleinere Schaltungsträger zu verwenden und diese beim Einbau in das Steuergerät miteinander zu verbinden und bauraumoptimiert im Steuergerät anzuordnen. Nachteilig ist jedoch, dass die Montage des Steuergeräts erschwert wird und die erforderlichen Steckverbinder selbst einen großen Anteil des zur Verfügung stehenden Bauraums einnehmen. Zudem ist ein Test der Hardware auf Bauteilschäden und fehlerhafte Lötstellen erst im zusammengebauten Zustand möglich. Eine optische Überprüfung im zusammengebauten Zustand ist ebenfalls aufwändig. Diese Nachteile erschweren den kosteneffizienten Einsatz von Multiboard-Systemen in Steuergeräten für Lenksysteme.

Aufgabe der Erfindung ist es daher ein Steuergerät für ein Lenksystem eines Kraftfahrzeugs, eine elektromechanische Kraftfahrzeugservolenkung und ein Steer-by-Wire Lenksystem zu schaffen, die kleinbauend sind und sich zugleich schnell und einfach zusammenbauen lassen.

Diese Aufgabe wird gelöst durch ein Steuergerät für ein Lenksystem eines Kraftfahrzeugs mit den Merkmalen des Anspruchs 1, sowie durch eine elektromechanische Kraftfahrzeugservolenkung mit den Merkmalen des Anspruchs 8 und ein Steer-by-Wire Lenksystem mit den Merkmalen des Anspruchs 9.

Hierdurch wird ein Steuergerät für ein Lenksystem eines Kraftfahrzeugs geschaffen mit einer auf einer Leiterplatte angeordneten Geräteelektronik. Die Geräteelektronik umfasst eine Steuerelektronik, ein Leistungsmodul und eine Stromzuführung. Die Steuerelektronik ist ausgebildet zur Verarbeitung von Eingabesignalen unter Ausgabe von Steuersignalen an das Leistungsmodul. Das Leistungsmodul weist Kontaktpunkte für den Anschluss eines Lenkstellmotors auf zur Ansteuerung des Lenkstellmotors in Abhängigkeit der empfangenen Steuersignale. Bei dem erfindungsgemäßen Steuergerät ist die Leiterplatte als eine Starrflex-Leiterplatte ausgebildet mit mindestens zwei durch mindestens einen ersten flexiblen Abschnitt verbundenen starren Schaltungsträgern. Auf jeweils einem der Schaltungsträger sind die Steuerelektronik und entsprechend das Leistungsmodul angeordnet. Für die Stromzuführung ist an dem Schaltungsträger des Leistungsmoduls ein zweiter flexibler Abschnitt der Leiterplatte ausgebildet.

Durch die Ausbildung der Leiterplatte als Starrflex-Leiterplatte ist es möglich, die gesamte Geräteelektronik des Steuergeräts auf einer einzigen Leiterplatte anzuordnen und platzsparend im Steuergerät zu verbauen. Dies hat den Vorteil, dass die Geräteelektronik vor dem Einbau vollständig auf Funktionsfähigkeit geprüft werden kann und auch die Sichtprüfung vereinfacht wird. Der Einbau der Leiterplatte in das Steuergerät ist vereinfacht, da keine Steckverbindungen zwischen Leiterplatten hergestellt werden müssen. Durch die Verbindung der starren Schaltungsträger über den zumindest einen ersten flexiblen Abschnitt können die Schaltungsträger bauraumoptimiert im Steuergerät eingebaut werden.

Ein weiterer Vorteil des erfindungsgemäßen Aufbaus ist die optimierte Stromführung im Steuergerät. Die Anordnung des Leistungsmoduls auf einem gesonderten starren Schaltungsträger, der einstückig mit der Stromzuführung ausgebildet ist, erlaubt es, die erforderlichen hohen Motorströme auf direktem Wege und ohne Steckverbindungen dem Lenkstellmotor zuzuführen. Insbesondere können die Motorwicklungen mit den Kontaktpunkten des Leistungsmoduls fest verdrahtet werden. Durch die Verkürzung des Strompfades werden Materialkosten eingespart und die ohmschen Verluste minimiert. Die Stromversorgung der Steuerelektronik erfolgt mittelbar über den Schaltungsträger des Leistungsmoduls und den ersten flexiblen Abschnitt. Auf eine gesonderte Stromversorgung des Schaltungsträgers der Steuerelektronik kann somit vorteilhaft verzichtet werden. Aufgrund des im Vergleich zu den Motorströmen geringen Leistungsbedarfs der Steuerelektronik fällt der verlängerte Strompfad für die Steuerelektronik nicht ins Gewicht.

Vorzugsweise sind die beiden starren Schaltungsträger sich zumindest abschnittsweise überdeckend übereinander in dem Steuergerät angeordnet sind. Durch diese Anordnung wird der Bauraum im Steuergerät besonders gut ausgenutzt. Insbesondere kann vorgesehen sein, dass die starren Schaltungsträger im Wesentlichen deckungsgleich übereinander liegen.

In einer bevorzugten Ausführungsform ist das Steuergerät an dem Lenkstellmotor in Verlängerung von dessen Motorwelle befestigbar, wobei der Schaltungsträger des Leistungsmoduls motorseitig und der Schaltungsträger der Steuerelektronik auf der motorabgewandten Seite des Schaltungsträgers des Leistungsmoduls in dem Steuergerät angeordnet sind. Durch die motorseitige Anordnung des Leistungsmoduls wird der Strompfad für die Motorströme weiter verkürzt.

Weiterhin kann vorgesehen sein, dass die Steuerelektronik einen Rotorlagesensor umfasst und der Schaltungsträger des Leistungsmoduls eine dem Rotorlagesensor zugeordnete Aussparung zum Durchführen eines Geberelements für den Rotorlagesensor aufweist. Diese Ausführungsform ist insbesondere bei Anordnung des Steuergerätes in Verlängerung der Motorwelle des Lenkstellmotors vorteilhaft. Ein an der Motorwelle des Lenkstellmotors angebrachtes Geberelement kann durch die Aussparung des motorseitig vorgesehenen Schaltungsträgers des Leistungsmoduls hindurchgeführt werden, um in Wechselwirkung mit dem auf dem Schaltungsträger der Steuerelektronik angeordneten Rotorlagesensor zu treten. Der Rotorlagesensor kann so unmittelbar in die Steuerelektronik integriert werden, ohne die optimierte Anordnung der starren Schaltungsträger im Steuergerät zu verändern. Alternativ kann ein Rotorlagesensor auch auf dem Schaltungsträger des Leistungsmoduls oder einem weiteren gesonderten starren Schaltungsträger angeordnet sein.

In einer bevorzugten Ausführungsform sind ferner für den Empfang der Eingabesignale Steckverbinder vorgesehen, die sämtlich auf dem Schaltungsträger der Steuerelektronik angeordnet sind. Steckverbinder sind beim Design von Schaltungsträgern besonders zu berücksichtigen, da sie sowohl in der Ebene des Schaltungsträgers als auch in der Höhe einen beträchtlichen Bauraum einnehmen. Durch die Anordnung sämtlicher Steckverbinder für Eingangssignale des Steuergeräts auf dem Schaltungsträger der Steuerelektronik, können die beiden starren Schaltungsträger besonders nah aneinander angeordnet werden. Die Steckverbinder sind dabei vorzugsweise auf der dem Leistungsmodul abgewandten Seite des Schaltungsträgers angeordnet.

An dem flexiblen Abschnitt für die Stromzuführung kann ein dritter starrer Schaltungsträger ausgebildet sein, auf dem ein Steckverbinder zum Anschluss an ein Bordnetz des Kraftfahrzeugs angeordnet ist. Der dritte starre Schaltungsträger stellt eine feste Plattform für den Steckverbinder der Stromversorgung bereit, die am Gehäuse des Steuergerätes verankert werden kann. Alternativ kann aber auch unmittelbar am zweiten flexiblen Abschnitt ein Steckverbinder vorgesehen sein.

Die Schaltungsträger werden vorzugsweise durch Abstandselemente voneinander beabstandet, die an den Schaltungsträgern an jeweils einander zugeordneten Befestigungsstellen angebracht sind.

Die Erfindung betrifft ferner eine elektromechanische Kraftfahrzeugservolenkung umfassend eine Lenkmechanik zur mechanischen Übertragung eines Fahrerlenkwunsches von einem Lenkrad auf gelenkte Räder des Kraftfahrzeugs, einen Lenkwinkelsensor zur elektronischen Erfassung des Fahrerlenkwunsches und einen Lenkstellmotor zum Einbringen einer Lenckraftunterstützung in die Lenkmechanik. Zur Ansteuerung des Lenkstellmotors in Abhängigkeit des von dem Lenkwinkelsensor erfassten Fahrerlenkwunsches umfasst die Kraftfahrzeugservolenkung ein zuvor beschriebenes, erfindungsgemäßes Steuergerät.

In einer weiteren Ausführungsform betrifft die Erfindung ein Steer-by-Wire Lenksystem umfassend einen mit einem Lenkrad über eine Lenkwelle verbundenen Lenkwinkelsensor zur elektronischen Erfassung eines Fahrerlenkwunsches, einen Feedback-Aktuator und einen Lenkstellmotor zur Einstellung des erfassten Fahrerlenkwunsches an gelenkten Räder. Zur Ansteuerung des Lenkstellmotors in Abhängigkeit des von dem Lenkwinkelsensor erfassten Fahrerlenkwunsches umfasst das Steer-by-Wire Lenksystem ein zuvor beschriebenes, erfindungsgemäßes Steuergerät.

Weitere Ausgestaltungen der Erfindung sind der nachfolgenden Beschreibung und den Unteransprüchen zu entnehmen.

Die Erfindung wird nachstehend anhand der in den beigefügten Abbildungen dargestellten Ausführungsbeispiele näher erläutert.
- Fig. 1: zeigt schematisch den Aufbau eines Lenksystems mit einem Ausführungsbeispiel eines erfindungsgemäßen Steuergeräts,
- Fig. 2: zeigt schematisch eine Draufsicht auf die Leiterplatte des Steuergeräts gemäß dem Ausführungsbeispiel nach Fig. 1 im ausgebauten Zustand,
- Fig. 3: zeigt schematisch eine perspektivische Ansicht der Leiterplatte des Steuergeräts gemäß dem Ausführungsbeispiel nach Fig. 1 im ausgebauten Zustand,
- Fig. 4: zeigt schematisch eine perspektivische Ansicht der Leiterplatte des Steuergeräts gemäß dem Ausführungsbeispiel nach Fig. 1 im Einbauzustand.

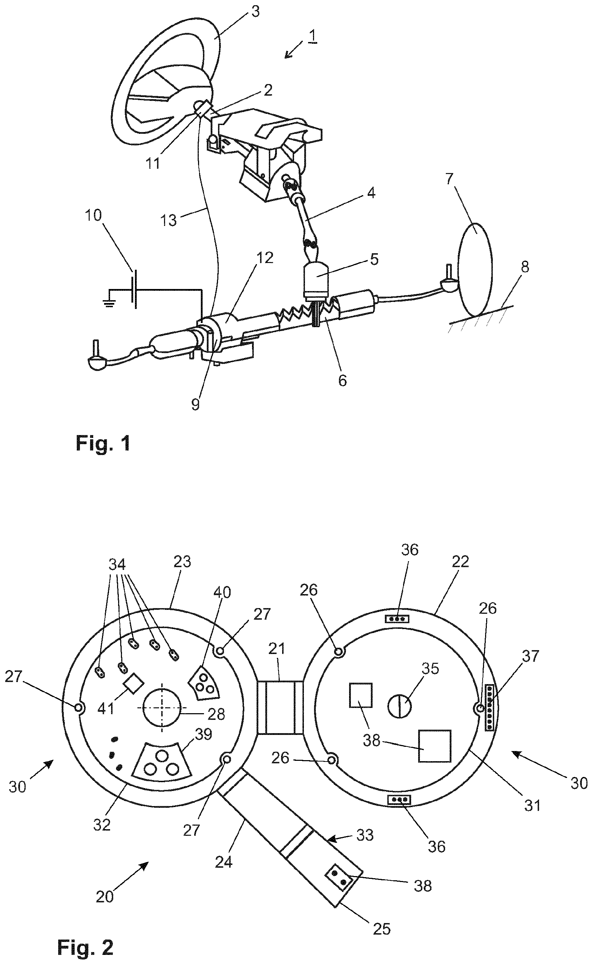

In Fig. 1 ist schematisch ein als elektromechanische Kraftfahrzeugservolenkung ausgebildetes Lenksystem 1 eines Kraftfahrzeugs mit einem erfindungsgemäßen Steuergerät 9 dargestellt, das der Ansteuerung des Lenksystems 1 dient. Das Lenksystem 1 weist ein an einer oberen Lenkwelle 2 befestigtes Lenkrad 3 auf. Der am Lenkrad 3 als Lenkwinkel eingegebene Fahrerlenkwunsch wird über die obere Lenkwelle 2 und die untere Lenkwelle 4 auf ein Lenkgetriebe 5 übertragen, das den Lenkwinkel in eine Translation einer Zahnstange 6 umsetzt. Die Zahnstange 6 ist über Spurstangen mit den gelenkten Rädern 7 verbunden, die in Kontakt mit der Fahrbahn 8 stehen. Lenkrad 3, Lenkwelle 2, 4, Lenkgetriebe 5 und Zahnstange 6 bilden somit eine Lenkmechanik zur mechanischen Übertragung eines Fahrerlenkwunsches von dem Lenkrad 3 auf die gelenkten Räder 7 des Kraftfahrzeugs.

Zum Bereitstellen einer Lenkkraftunterstützung umfasst das Lenksystem 1 ferner einen Lenkstellmotor 12, der in dem dargestellten Beispiel achsparallel zur Zahnstange 6 angeordnet ist und einen Spindeltrieb zur Längsverschiebung der Zahnstange 6 antreibt. Alternativ kann der Lenkstellmotor beispielsweise auch im Bereich der Lenkwelle 2, 4 angeordnet sein und die Lenkkraftunterstützung an der Lenkwelle 2, 4 in die Lenkmechanik einbringen.

Zur Ansteuerung des Lenkstellmotors 12 ist ein Steuergerät 9 vorgesehen, das unmittelbar an den Lenkstellmotor 12 in Verlängerung von dessen Motorwelle angeflanscht ist. Das Steuergerät 9 ist zur Stromversorgung an eine Bordnetzbatterie 10 angeschlossen. Das Steuergerät 9 ist ferner mit einem Lenkwinkelsensor 11 über eine Signalleitung 13 verbunden. Der Lenkwinkelsensor 11 kann beispielsweise als Drehwinkel-/Drehmoment-Sensor ausgebildet sein, der neben dem Drehwinkel auch das Drehmoment der Lenkradbetätigung erfassen kann.

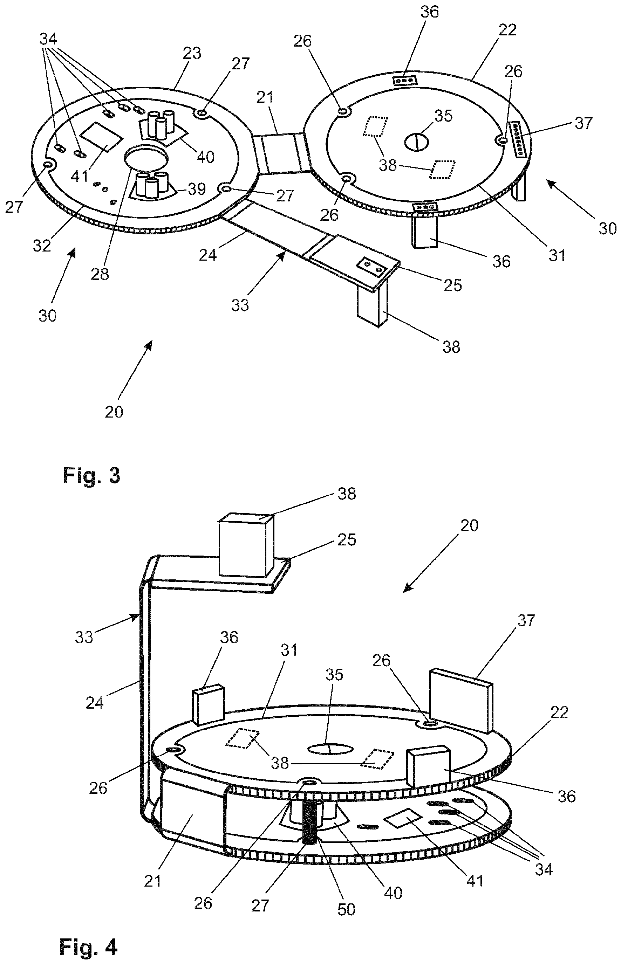

In Fig. 2 und 3 ist die Leiterplatte 20 des Steuergeräts 9 nach Fig. 1 im ausgebauten Zustand dargestellt. Auf der Leiterplatte 20 ist die gesamte Geräteelektronik 30 angeordnet. Die Leiterplatte 20 ist als eine Starrflex-Leiterplatte ausgebildet. Die Leiterplatte weist zwei starre Schaltungsträger 22, 23 auf, die mit einem flexiblen Abschnitt 21 verbunden sind. Auf dem Schaltungsträger 22 ist die Steuerelektronik 31 und auf dem Schaltungsträger 23 das Leistungsmodul 32 des Steuergerätes 9 angeordnet. Über den flexiblen Abschnitt 21 kann die Stromversorgung der Steuerelektronik 31 sowie die Übertragung von Steuersignalen an das Leistungsmodul 32 erfolgen. Als Stromzuführung 33 für das Steuergerät 9 ist an dem Leistungsmodul 32 ein zweiter flexibler Abschnitt 24 der Leiterplatte 20 ausgebildet. In dem dargestellten Ausführungsbeispiel ist an dem zweiten flexiblen Abschnitt 24 für die Stromzuführung 33 ein dritter starrer Schaltungsträger 25 ausgebildet, auf dem ein Steckverbinder 38 zum Anschluss an ein Bordnetz des Kraftfahrzeugs vorgesehen ist.

Die Bordnetzspannung wird über die Stromzuführung 33 unmittelbar dem Leistungsmodul 32 zugeführt. Das Leistungsmodul 32 umfasst beispielsweise Glättungskondensatoren 39, die die elektromagnetische Rückwirkung des für die Motoransteuerung verwendeten Wechselrichters 41 auf das Bordnetz reduzieren. Zur Ansteuerung von in dem Wechselrichter 41 vorgesehen MOSFETs ist eine Gate-Treiber-Einheit 40 vorgesehen, die Kondensatoren umfasst, um die Gate-Elektroden der MOSFETs umzuladen. Mit dem Wechselrichter 41 sind die Kontaktpunkte 34 verbunden, an denen die Motorwicklungen des Lenkstellmotors 12, beispielsweise durch Verlöten, angeschlossen werden können.

Die Steuerelektronik 31 des Steuergeräts 9 kann beispielsweise mehrkanalig redundant aufgebaut sein. Im dargestellten Ausführungsbeispiel weist die Steuerelektronik zwei voneinander unabhängige Signalverarbeitungskanäle auf. Hierzu umfasst die Steuerelektronik 31 zwei Mikroprozessoren 38 und zwei Steckverbinder 36 für den Anschluss eines (zweifach redundant ausgebildeten) Lenkwinkelsensors 11. Die Steuerelektronik 31 umfasst ferner einen weiteren Steckverbinder 37 für den Anschluss an ein Kraftfahrzeugbussystem. Über das Bussystem können weitere Eingabesignale, wie beispielsweise die Fahrzeuggeschwindigkeit oder ein Zündungssignal zum An- und Abschalten des Steuergerätes 9, zur Verfügung gestellt werden.

Auf dem Schaltungsträger 22 der Steuerelektronik 31 ist ferner ein Rotorlagesensor 35 angeordnet. Der Rotorlagesensor 35 ist vorzugsweise ebenfalls zumindest zweifach redundant ausgebildet. Auf dem Schaltungsträger 23 des Leistungsmoduls 32 ist eine dem Rotorlagesensor 35 zugeordnete Aussparung 28 zum Durchführen eines Geberelementes für den Rotorlagesensor 35 vorgesehen. Im Einbauzustand (vgl. Fig. 4) ist der Rotorlagesensor 35 oberhalb der Aussparung 28 angeordnet, so dass ein durch die Aussparung 28 hindurchgeführtes Geberelement unmittelbar mit dem Rotorlagesensor 35 in Wechselwirkung treten kann. Der Rotorlagesensor 35 ist vorzugsweise als magnetischer oder induktiver Sensor ausgebildet. Als magnetischer Sensor kann beispielsweise ein Hall- oder AMR-Sensor verwendet werden.

Auf den Schaltungsträgern 22, 23 können jeweils einander zugeordnete Befestigungsstellen 26, 27 vorgesehen sein zum Anbringen von Abstandselementen 50 (vgl. Fig. 4), die die Schaltungsträger 22, 23 voneinander beabstanden. Die Form der Schaltungsträger 22, 23 ist im Ausführungsbeispiel kreisförmig. Es können jedoch auch beliebige andere Schaltungsträgerformen, beispielsweise vier- oder mehreckig, gewählt werden.

Fig. 4 zeigt die Leiterplatte 20 gemäß Fig. 2 und 3 im Einbauzustand. Der flexible Abschnitt 21 ist im Einbauzustand, vorzugsweise U-förmig, umgebogen, so dass die starren Schaltungsträger 22, 23 sich zumindest abschnittsweise überdeckend übereinander in dem Steuergerät 9 angeordnet sind. Im dargestellten Beispiel sind die Schaltungsträger 22, 23 im Wesentlichen parallel und deckungsgleich zueinander angeordnet.

Der zweite flexible Abschnitt 24 für die Stromzuführung 33 ist vorzugsweise im Einbauzustand an dem Schaltungsträger 22 der Steuerelektronik 31 seitlich vorbeigeführt hin zu einer Anschlussseite des Steuergeräts 9. In dem dargestellten Ausführungsbeispiel ist an dem flexiblen Abschnitt 24 für die Stromzuführung 33 ein dritter starrer Schaltungsträger 25 ausgebildet, auf dem ein Steckverbinder 38 zum Anschluss an ein Bordnetz des Kraftfahrzeugs angeordnet ist. Der Anschluss für die Stromversorgung (im Beispiel Steckverbinder 38) kann oberhalb des Schaltungsträgers 22 angeordnet sein. Die Flexibilität des flexiblen Abschnitts 24 kann aber auch genutzt werden, um den Anschluss für die Stromversorgung beispielsweise seitlich anzuordnen.

Fig. 4 ist der Vorteil einer Anordnung sämtlicher Steckverbinder 36, 37 für Eingabesignale auf dem Schaltungsträger 22 der Steuerelektronik 31 zu erkennen. Während die übrigen verbauten Elektronikkomponenten, wie Widerstände, Kondensatoren, Spulen und Mikroprozessoren, Bauhöhen von einem oder wenigen Millimetern nicht überschreiten, weisen Steckverbinder Bauhöhen von bis zu 1 bis 2 cm auf. Durch die Anordnung der Steckverbinder auf dem oberen Schaltungsträger 22 können die Schaltungsträger 22, 23 besonders platzsparend übereinander angeordnet werden. Durch den flexiblen Abschnitt 21 zur Verbindung der Schaltungsträger 22, 23 werden vorzugsweise ausschließlich Steckverbinder für externe Komponenten benötigt. Der flexible Abschnitt 21 ermöglicht somit zusätzliche Freiheiten beim 3D-Design der Schaltungsträgeranordnung.

Wird das Steuergerät 9 wie in Fig. 1 gezeigt an dem Lenkstellmotor 12 in Verlängerung von dessen Motorwelle befestigt, ist der Schaltungsträger 23 des Leistungsmoduls 32 vorzugsweise motorseitig und der Schaltungsträger 22 der Steuerelektronik 31 auf der motorabgewandten Seite des Schaltungsträgers 23 des Leistungsmoduls 32 in dem Steuergerät 9 angeordnet.

Obwohl die Erfindung im vorstehenden Ausführungsbeispiel anhand einer elektromechanischen Kraftfahrzeugservolenkung und einem Steuergerät hierfür erläutert wurde, kann das erfindungsgemäße Steuergerät in gleicher Weise in einem Steer-by-Wire Lenksystem umfassend einen mit einem Lenkrad über eine Lenkwelle verbundenen Lenkwinkelsensor zur elektronischen Erfassung eines Fahrerlenkwunsches, einen Feedback-Aktuator und einen Lenkstellmotor zur Einstellung des erfassten Fahrerlenkwunsches an gelenkten Räder zur Ansteuerung des Lenkstellmotors in Abhängigkeit des von dem Lenkwinkelsensor erfassten Fahrerlenkwunsches eingesetzt werden.

Die erfindungsgemäße Lösung schafft ein Steuergerät, das sich besonders einfach und platzsparend zusammenbauen lässt und der Geräteelektronik durch die Anordnung auf einer einzigen Leiterplatte nichtsdestotrotz vor dem Einbau einfach optisch und elektronisch auf Fehler überprüfbar ist. Überdies ist die Anzahl der Steckverbinder auf die notwendigen externen Steckverbindungen reduziert. Da die flexiblen Abschnitte während des Einbaus nur einmalig in Form gebracht werden müssen, stellt auch die begrenzte Anzahl von ca. 50 Biegezyklen von Starrflex-Leiterplatten keinen limitierenden Faktor in der Produktion dar. Im Hinblick auf im Betrieb auftretende Vibrationen ist die Verwendung eine Starrflex-Leiterplatte zudem vorteilhaft, da die flexiblen Abschnitte (aufgrund ihrer geringen Dicke von beispielsweise 0,2mm) nur eine vernachlässigbare Masse aufweisen und damit eine vibrationssichere Verbindung bereitstellen.

### Bezugszeichenliste

- 1: Lenksystem
- 2: obere Lenkwelle
- 3: Lenkrad
- 4: untere Lenkwelle
- 5: Lenkgetriebe
- 6: Spurstangen
- 7: Räder
- 8: Fahrbahn
- 9: Steuergerät
- 10: Bordnetzbatterie
- 11: Lenkwinkelsensor
- 12: Lenkstellantrieb
- 13: Signalleitung
- 20: Leiterplatte
- 21: erster flexibler Abschnitt
- 22, 23: Schaltungsträger
- 24: zweiter flexibler Abschnitt
- 25: Schaltungsträger
- 26, 27: Befestigungsstellen
- 28: Aussparung
- 30: Geräteelektronik
- 31: Steuerelektronik
- 32: Leistungsmodul
- 33: Stromzuführung
- 34: Kontaktpunkte
- 35: Rotorlagesensor
- 36, 37: Steckverbinder
- 38: Mikroprozessor
- 39: Glättungskondensatoren
- 40: Gate-Treibereinheit
- 41: Wechselrichter
- 50: Abstandselemente

## Patentansprüche

1. Steuergerät für ein Lenksystem (1) eines Kraftfahrzeugs mit einer auf einer Leiterplatte (20) angeordneten Geräteelektronik (30), die eine Steuerelektronik (31), ein Leistungsmodul (32) und eine Stromzuführung (33) umfasst, wobei die Steuerelektronik (31) zur Verarbeitung von Eingabesignalen unter Ausgabe von Steuersignalen an das Leistungsmodul (32) ausgebildet ist und das Leistungsmodul (32) Kontaktpunkte (34) für den Anschluss eines Lenkstellmotors (12) aufweist zur Ansteuerung des Lenkstellmotors (12) in Abhängigkeit der Steuersignale, wobei die Leiterplatte (20) mit mindestens zwei durch mindestens einen ersten flexiblen Abschnitt (21) verbundenen starren Schaltungsträgern (22, 23) ausgebildet ist, und auf jeweils einem der Schaltungsträger (22, 23) die Steuerelektronik (31) und entsprechend das Leistungsmodul (32) angeordnet sind, **dadurch gekennzeichnet, dass** die Leiterplatte (20) als eine Starrflex-Leiterplatte ausgebildet ist und für die Stromzuführung (33) an dem Schaltungsträger (23) des Leistungsmoduls (32) ein zweiter flexibler Abschnitt (24) der Leiterplatte (20) ausgebildet ist.

2. Steuergerät nach Anspruch 1, **dadurch gekennzeichnet, dass** die beiden starren Schaltungsträger (22, 23) sich zumindest abschnittsweise überdeckend übereinander in dem Steuergerät (9) angeordnet sind.

3. Steuergerät nach Anspruch 1 oder 2, **dadurch gekennzeichnet, dass** das Steuergerät (9) an dem Lenkstellmotor (12) in Verlängerung von dessen Motorwelle befestigbar ist, wobei der Schaltungsträger (23) des Leistungsmoduls (32) motorseitig und der Schaltungsträger (22) der Steuerelektronik (31) auf der motorabgewandten Seite des Schaltungsträgers (23) des Leistungsmoduls (32) in dem Steuergerät (9) angeordnet sind.

4. Steuergerät nach einem der Ansprüche 1 bis 3, **dadurch gekennzeichnet, dass** die Steuerelektronik (31) einen Rotorlagesensor (35) umfasst und der Schaltungsträger (23) des Leistungsmoduls (32) eine dem Rotorlagesensor (35) zugeordnete Aussparung (28) zum Durchführen eines Geberelements für den Rotorlagesensor (35) aufweist.

5. Steuergerät nach einem der Ansprüche 1 bis 4, **dadurch gekennzeichnet, dass** für den Empfang der Eingabesignale Steckverbinder (36, 37) vorgesehen sind, die sämtlich auf dem Schaltungsträger (22) der Steuerelektronik (31) angeordnet sind.

6. Steuergerät nach einem der Ansprüche 1 bis 5, **dadurch gekennzeichnet, dass** an dem flexiblen Abschnitt (24) für die Stromzuführung (33) ein dritter starrer Schaltungsträger (25) ausgebildet ist, auf dem ein Steckverbinder (38) zum Anschluss an ein Bordnetz des Kraftfahrzeugs angeordnet ist.

7. Steuergerät nach einem der Ansprüche 1 bis 6, **dadurch gekennzeichnet, dass** die Schaltungsträger (22, 23) durch Abstandselemente (50) voneinander beabstandet sind, die an den Schaltungsträgern (22, 23) an jeweils einander zugeordneten Befestigungsstellen (26, 27) angebracht sind.

8. Elektromechanische Kraftfahrzeugservolenkung umfassend eine Lenkmechanik zur mechanischen Übertragung eines Fahrerlenkwunsches von einem Lenkrad (3) auf gelenkte Räder (7) des Kraftfahrzeugs, einen Lenkwinkelsensor (11) zur elektronischen Erfassung des Fahrerlenkwunsches und einen Lenkstellmotor (12) zum Einbringen einer Lenkkraftunterstützung in die Lenkmechanik, **dadurch gekennzeichnet, dass** die Kraftfahrzeugservolenkung zur Ansteuerung des Lenkstellmotors (12) in Abhängigkeit des von dem Lenkwinkelsensor (11) erfassten Fahrerlenkwunsches ein Steuergerät (9) nach einem der Ansprüche 1 bis 7 umfasst.

9. Steer-by-Wire Lenksystem umfassend einen mit einem Lenkrad über eine Lenkwelle verbundenen Lenkwinkelsensor zur elektronischen Erfassung eines Fahrerlenkwunsches, einen Feedback-Aktuator und einen Lenkstellmotor zur Einstellung des erfassten Fahrerlenkwunsches an gelenkten Räder, **dadurch gekennzeichnet, dass** das Steer-by-Wire Lenksystem zur Ansteuerung des Lenkstellmotors in Abhängigkeit des von dem Lenkwinkelsensor erfassten Fahrerlenkwunsches ein Steuergerät nach einem der Ansprüche 1 bis 7 umfasst.

## Claims

1. A control unit for a steering system (1) of a motor vehicle with device electronics (30) arranged on a circuit board (20) comprising control electronics (31), a power module (32) and a current feed (33), wherein the control electronics (31) are designed for processing input signals with the output of control signals to the power module (32) and the power module (32) has contact points (34) for the connection of a steering servo motor (12) for actuating the steering servo motor (12) depending on the control signals, wherein the circuit board (20) has at least two rigid circuit carriers (22, 23) connected by at least one flexible section (21), wherein the control electronics (31) and the power module (32) are arranged on each of the circuit carriers (22, 23), respectively, **characterized in that** the circuit board is in the form of a rigid-flex circuit board, wherein a second flexible section (24) of the circuit board (20) is formed for the current feed (33) on the circuit carrier (23) of the power module (32).

2. The control unit as claimed in claim 1, **characterized in that** the two rigid circuit carriers (22, 23) are arranged at least partially overlapping one on top of the other in the control unit (9).

3. The control unit as claimed in claim 1 or 2, **characterized in that** the control unit (9) can be attached to the steering servo motor (12) as an extension of its motor shaft, wherein the circuit carrier (23) of the power module (32) is arranged on the motor side and the circuit carrier (22) of the control electronics (31) is arranged on the side of the power module (32) facing away from the motor of the circuit carrier (23) in the control unit (9).

4. The control unit as claimed in any one of claims 1 to 3, **characterized in that** the control electronics (31) comprise a rotor position sensor (35) and the circuit carrier (23) of the power module (32) has an aperture (28) associated with the rotor position sensor (35) for feeding through an encoder element for the rotor position sensor (35).

5. The control unit as claimed in any one of claims 1 to 4, **characterized in that** for the reception of the input signals plug connectors (36, 37) are provided, all of which are arranged on the circuit carrier (22) of the control electronics (31).

6. The control unit as claimed in any one of claims 1 to 5, **characterized in that** a third rigid circuit carrier (25), on which a plug connector (38) for connection to an on-board electrical system of the motor vehicle is arranged, is formed on the flexible section (24) for the current feed (33).

7. The control unit as claimed in any one of claims 1 to 6, **characterized in that** the circuit carriers (22, 23) are distanced from each other by spacer elements (50) which are attached to the circuit carriers (22, 23) at mutually associated fastening points (26, 27).

8. An electromechanical motor vehicle servo steering system comprising a steering mechanism for the mechanical transmission of a driver's steering request from a steering wheel (3) to steered wheels (7) of the motor vehicle, a steering angle sensor (11) for electronic detection of the driver's steering request and a steering servo motor (12) for introducing steering force assistance into the steering mechanism, **characterized in that** the motor vehicle servo steering system comprises a control unit (9) as claimed in any one of claims 1 to 7 for actuating the steering servo motor (12) depending on the driver's steering request detected by the steering angle sensor (11).

9. A steer-by-wire steering system comprising a steering angle sensor connected to a steering wheel via a steering shaft for the electronic detection of a driver's steering request, a feedback actuator and a steering servo motor for setting the detected driver's steering request on the steered wheels, **characterized in that** the steer-by-wire steering system comprises a control unit as claimed in any one of claims 1 to 7 for actuating the steering servo motor depending on the driver's steering request detected by the steering angle sensor.

## Revendications

1. Appareil de commande pour un système de direction (1) d'un véhicule automobile avec une électronique d'appareil (30) disposé sur une carte de circuit imprimé (20) comprenant une électronique de commande (31), un module de puissance (32) et une alimentation en courant (33), dans laquelle l'électronique de commande (31) est conçu pour traiter les signaux d'entrée avec la sortie de signaux de commande vers le module de puissance (32) et le module de puissance (32) a des points de contact (34) pour la connexion d'un servomoteur de direction (12) pour l'actionnement du servomoteur de direction (12) en fonction des signaux de commande, la carte de circuit imprimé (20) comporte au moins deux supports de circuit rigides (22, 23) reliés par au moins une section flexible (21), l'électronique de commande (31) et le module de puissance (32) étant disposés respectivement sur chacun des supports de circuit (22, 23), **caractérisé en ce que** la carte de circuit imprimé se présente sous la forme d'une carte de circuit imprimé rigide-flexible, une deuxième section flexible (24) de la carte de circuit imprimé (20) étant formée pour l'alimentation en courant (33) sur le support de circuit (23) du module de puissance (32).

2. L'appareil de commande selon la revendication 1, **caractérisée en ce que** les deux supports de circuit rigides (22, 23) sont disposés au moins partiellement l'un sur l'autre dans l'appareil de commande (9).

3. L'appareil de commande selon la revendication 1 ou 2, **caractérisée en ce que** l'appareil de commande (9) peut être fixée au servomoteur de direction (12) comme une extension de son arbre moteur, dans laquelle le support de circuit (23) du module de puissance (32) est disposé du côté du moteur et le support de circuit (22) de l'électronique de commande (31) est disposé du côté du module de puissance (32) opposé au moteur du support de circuit (23) dans l'appareil de commande (9).

4. L'appareil de commande selon l'une des revendications 1 à 3, **caractérisée en ce que** l'électronique de commande (31) comprend un capteur de position du rotor (35) et que le support de circuit (23) du module de puissance (32) présente une ouverture (28) associée au capteur de position du rotor (35) pour le passage d'un élément de codage pour le capteur de position du rotor (35).

5. L'appareil de commande selon l'une des revendications 1 à 4, **caractérisée par la présence de** connecteurs (36, 37) pour la réception des signaux d'entrée, tous disposés sur le support de circuit (22) de l'électronique de commande (31).

6. L'appareil de commande selon l'une des revendications 1 à 5, **caractérisée en ce qu'**un troisième support de circuit rigide (25), sur lequel est disposé un connecteur (38) pour la connexion à un système électrique embarqué du véhicule à moteur, est formé sur la section flexible (24) pour l'alimentation en courant (33).

7. L'appareil de commande selon l'une des revendications 1 à 6, **caractérisée en ce que** les supports de circuit (22, 23) sont séparés les uns des autres par des éléments d'espacement (50) qui sont fixés aux supports de circuit (22, 23) à des points de fixation (26, 27) associés les uns aux autres.

8. Système de direction assistée électromécanique pour véhicule automobile comprenant un mécanisme de direction pour la transmission mécanique de la demande de direction du conducteur d'un volant (3) aux roues directrices (7) du véhicule automobile, un capteur d'angle de direction (11) pour la détection électronique de la demande de direction du conducteur et un servomoteur de direction (12) pour introduire l'assistance de la force de direction dans le mécanisme de direction, **caractérisé en ce que** le système de direction assistée du véhicule à moteur comprend une appareil de commande (9) telle que revendiquée dans l'une quelconque des revendications 1 à 7 pour actionner le servomoteur de direction (12) en fonction de la demande de direction du conducteur détectée par le capteur d'angle de direction (11).

9. Système de direction à commande électrique comprenant un capteur d'angle de braquage relié à un volant par l'intermédiaire d'un arbre de direction pour la détection électronique de la demande de braquage du conducteur, un actionneur de rétroaction et un servomoteur de direction pour régler la demande de braquage du conducteur détectée sur les roues directrices, **caractérisé en ce que** le système de direction à commande électrique comprend une appareil de commande selon l'une quelconque des revendications 1 à 7 pour actionner le servomoteur de direction en fonction de la demande de braquage du conducteur détectée par le capteur d'angle de braquage.
